# NEUE EUROPÄISCHE PATENTSCHRIFT

(11) **EP 2 896 269 B2**
(45) Veröffentlichungstag und Bekanntmachung des Hinweises auf die Entscheidung über den Einspruch: **03.06.2020**
(45) Hinweis auf die Patenterteilung: 15.03.2017
(21) Anmeldenummer: 13735270.4
(22) Anmeldetag: 10.07.2013
(51) Int. Cl.: H05B 3/84, H01R 12/57, H01R 12/53

(54) **SCHEIBE MIT EINEM ELEKTRISCHEN ANSCHLUSSELEMENT**
PANE WITH ELECTRIC CONNECTION ELEMENT
DISQUE DOTÉ D'UN ÉLÉMENT DE RACCORDEMENT ÉLECTRIQUE

(30) Priorität: 14.09.2012 EP 12184408
(43) Veröffentlichungstag der Anmeldung: 22.07.2015
(60) Teilanmeldung: 17152958.9
(73) Patentinhaber: Saint-Gobain Glass France, 92400 Courbevoie (FR)
(72) Erfinder: SCHMALBUCH, Klaus, 52074 Aachen (DE); REUL, Bernhard, 52134 Herzogenrath (DE); RATEICZAK, Mitja, 52146 Würselen (DE); LESMEISTER, Lothar, NL-6373 Landgraaf (NL)
(74) Vertreter: Gebauer, Dieter Edmund
(86) Internationale Anmeldenummer: PCT/EP2013/064575
(87) Internationale Veröffentlichungsnummer: WO 2014/040773

(56) Entgegenhaltungen:
- EP-A1- 2 299 544
- EP-A1- 2 408 260
- WO-A1-2011/107342
- WO-A1-2012/007303
- WO-A1-2012/152543
- DE-A1-102010 018 860
- DE-C1- 10 046 489
- DE-U1- 20 203 202
- US-A- 2 644 066
- US-A1- 2007 224 842

## Beschreibung

Die Erfindung betrifft eine Scheibe mit einem elektrischen Anschlusselement, ein wirtschaftliches und umweltfreundliches Verfahren zu deren Herstellung und ihre Verwendung.

Die Erfindung betrifft insbesondere eine Scheibe mit einem elektrischen Anschlusselement für Fahrzeuge mit elektrisch leitfähigen Strukturen wie beispielsweise Heizleiter oder Antennenleiter. Die elektrisch leitfähigen Strukturen sind üblicherweise über angelötete elektrische Anschlusselemente mit der Bordelektrik verbunden. Aufgrund unterschiedlicher thermischer Ausdehnungskoeffizienten der verwendeten Materialien treten mechanische Spannungen bei der Herstellung und im Betrieb auf, welche die Scheiben belasten und den Bruch der Scheibe hervorrufen können.

Bleihaltige Lote weisen eine hohe Duktilität auf, die auftretende mechanische Spannungen zwischen elektrischem Anschlusselement und der Scheibe durch plastische Deformierung kompensieren können. Allerdings müssen aufgrund der Altauto-Richtlinie 2000/53/EG innerhalb der EG bleihaltige Lote durch bleifreie Lote ersetzt werden. Die Richtlinie wird zusammenfassend mit dem Kürzel ELV (End of life vehicles) bezeichnet. Das Ziel ist dabei, im Zuge der massiven Ausweitung von Wegwerfelektronik äußerst problematische Bestandteile aus den Produkten zu verbannen. Die betroffenen Substanzen sind Blei, Quecksilber und Cadmium. Das betrifft unter anderem die Durchsetzung von bleifreien Lötmitteln in elektrischen Anwendungen auf Glas und die Einführung entsprechender Ersatzprodukte hierzu.

Es sind eine Reihe von elektrischen Anschlusselementen zum bleifreien Verlöten mit elektrisch leitfähigen Strukturen vorgeschlagen worden. Beispielhaft sei auf die Dokumente US 20070224842 A1, EP 1942703 A2, WO 2007110610 A1, EP 1488972 A1 und EP 2365730 A1 verwiesen. Eine entscheidende Bedeutung hinsichtlich der Vermeidung von thermischen Spannungen kommt einerseits der Form des Anschlusselements und andererseits dem Material des Anschlusselements zu.

DE 10046489 C1 zeigt eine Anordnung, bei der eine elektrische Leiterbahn an eine Anschlussfläche gelötet ist. EP 2299544 A1 zeigt eine Anordnung, bei der ein Leiter durch einen Crimp mit einem flächigen Anschlussteil verbunden ist. Nur das flächige Anschlussteil ist mit einer Anschlussfläche verbunden. DE 102010018860 A1 zeigt eine Anordnung, bei der ein Crimp ohne Lötverbindung mit einer Anschlussfläche verbunden ist.

Das Dokument WO 2012/007303 A1 offenbart eine Scheibe mit mindestens einem elektrischen Anschlusselement, mit einer elektrisch leitfähige Struktur auf einem Bereich eines Substrats, einem Anschlusselement auf einem Bereich der elektrisch leitfähigen Struktur, wobei das Anschlusselement einen um ein Anschlusskabel gecrimpten Bereich aufweist, wobei der gecrimpte Bereich des Anschlusselements über eine Lotmasse mit der elektrisch leitfähigen Struktur direkt verbunden ist. Dieses Dokument macht keine Angaben über Art oder Orientierung des Crimps, und offenbart kein Anschlusselement, das einen chromhaltigen Stahl enthält.

Das Dokument WO 2012/152543 A1 ist als EP 2708091 A1 Stand der Technik nach Artikel 54(3) EPÜ, und offenbart ebenfalls eine Scheibe mit mindestens einem elektrischen Anschlusselement, mit einer elektrisch leitfähige Struktur auf einem Bereich eines Substrats, einem Anschlusselement, das zumindest einen chromhaltigen Stahl enthält, auf einem Bereich der elektrisch leitfähigen Struktur, wobei das Anschlusselement einen um ein Anschlusskabel gecrimpten Bereich aufweist, wobei der gecrimpte Bereich des Anschlusselements über eine Lotmasse mit der elektrisch leitfähigen Struktur direkt verbunden ist. Dieses Dokument macht keine Angaben über Art oder Orientierung des Crimps.

Die Aufgabe der vorliegenden Erfindung ist es, eine Scheibe mit einem elektrischen Anschlusselement bereitzustellen, welches sich insbesondere zum Verlöten mittels bleifreier Lotmassen eignet, wobei kritische mechanische Spannungen in der Scheibe vermieden werden. Außerdem soll ein wirtschaftliches und umweltfreundliches Verfahren zu deren Herstellung bereitgestellt werden.

Die Aufgabe der vorliegenden Erfindung wird erfindungsgemäß durch eine Scheibe mit mindestens einem elektrischen Anschlusselement gemäß dem unabhängigen Anspruch 1 gelöst. Bevorzugte Ausführungen gehen aus den Unteransprüchen hervor.

Die erfindungsgemäße Scheibe mit mindestens einem elektrischen Anschlusselement umfasst zumindest die folgenden Merkmale:
- ein Substrat,
- auf einem Bereich des Substrats eine elektrisch leitfähige Struktur,
- auf einem Bereich der elektrisch leitfähigen Struktur ein Anschlusselement, das zumindest einen chromhaltigen Stahl enthält,
wobei das Anschlusselement einen um ein Anschlusskabel gecrimpten Bereich aufweist und wobei der gecrimpte Bereich des Anschlusselements über eine Lotmasse mit der elektrisch leitfähigen Struktur verbunden ist.

Das elektrische Anschlusselement ist erfindungsgemäß durch Crimpen mit dem Anschlusskabel verbunden. Die Crimpverbindung ist einfach, kostengünstig und schnell herzustellen und leicht automatisierbar. Aufwendige zusätzliche Prozessschritte, beispielsweise das Verlöten oder Verschweißen des Anschlusselements mit dem Anschlusskabel können vermieden werden. Gleichzeitig wird eine sehr stabile Verbindung zwischen Anschlusselement und Anschlusskabel bereitgestellt. Da der gecrimpte Bereich des Anschlusselements (der sogenannte Crimp, also der durch den Crimpvorgang verformte Bereich) direkt mit der elektrisch leitfähigen Struktur verlötet wird, und nicht etwa ein an die Crimpverbindung angeschlossener Abschnitt des Anschlusselements, kann das Anschlusselement mit vorteilhaft kleinen Abmessungen ausgestaltet werden, wodurch der Platzbedarf der elektrischen Kontaktierung verringert wird. Zudem bewirkt das Anschlusselement bei mechanischer Belastung des Anschlusskabels, insbesondere Zug auf das Anschlusskabel, keinen oder nur einen sehr geringen Hebelarm, was zu einer vorteilhaften Stabilität der Lötverbindung führt. Das gecrimpte Anschlusselement kann außerdem eine Materialstärke aufweisen, welche deutlich geringer ist als die Materialstärke herkömmlicher Anschlusselemente. Dadurch werden einerseits mechanische Spannungen im Substrat reduziert und andererseits niedrigere Prozesstemperaturen beim Löten ermöglicht, wodurch das Bruchrisiko gesenkt und die Prozessdauer verkürzt wird.

Chromhaltiger, insbesondere sogenannter rostfreier oder nichtrostender Stahl ist kostengünstig verfügbar. Anschlusselemente aus chromhaltigem Stahl weisen zudem im Vergleich zu vielen herkömmlichen Anschlusselementen, beispielsweise aus Kupfer, eine hohe Steifigkeit auf, was zu einer vorteilhaften Stabilität der Crimpverbindung führt. Chromhaltiger Stahl ist gut kaltumformbar, wodurch er sich zur Herstellung von Crimpverbindung besonders eignet. Zudem weist chromhaltiger Stahl im Vergleich zu vielen herkömmlichen Anschlusselementen, beispielsweise solche aus Titan, eine verbesserte Lötbarkeit auf, die sich aus einer höheren Wärmeleitfähigkeit ergibt.

Das Anschlusskabel ist dafür vorgesehen, die elektrisch leitfähige Struktur mit einem externen Funktionselement, beispielsweise einer Spannungsversorgung oder einem Empfangsgerät, elektrisch zu verbinden. Dazu ist das Anschlusskabel ausgehend vom Anschlusselement bevorzugt über die Seitenkanten der Scheibe hinweg von der Scheibe weggeführt. Das Anschlusskabel kann prinzipiell jedes Anschlusskabel sein, das dem Fachmann zur elektrischen Kontaktierung einer elektrisch leitfähigen Struktur bekannt ist und dazu geeignet ist, durch Crimpen mit dem Anschlusselement (auch Crimpkontakt genannt) verbunden zu werden. Das Anschlusskabel kann neben einem elektrisch leitfähigen Kern (Innenleiter) eine isolierende, bevorzugt polymere Ummantelung umfassen, wobei die isolierende Ummantelung bevorzugt im Endbereich des Anschlusskabels entfernt ist, um eine elektrisch leitende Verbindung zwischen Anschlusselement und Innenleiter zu ermöglichen.

Der elektrisch leitfähige Kern des Anschlusskabels kann beispielsweise Kupfer, Aluminium und / oder Silber oder Legierungen oder Gemische davon enthalten. Der elektrisch leitfähige Kern ist bevorzugt als Drahtlitzenleiter ausgeführt, kann aber auch beispielsweise als Volldrahtleiter ausgeführt sein. Der Querschnitt des elektrisch leitfähigen Kerns des Anschlusskabels richtet sich nach der für die Verwendung der erfindungsgemäßen Scheibe erforderlichen Stromtragfähigkeit und kann vom Fachmann geeignet gewählt werden. Der Querschnitt beträgt beispielsweise von 0,3 mm² bis 6 mm².

Das Anschlusselement, welches erfindungsgemäß zumindest einen chromhaltigen Stahl enthält und bevorzugt aus dem chromhaltigen Stahl besteht, ist bevorzugt im Endbereich des Anschlusskabels um den elektrisch leitfähigen Kern des Anschlusskabels gecrimpt, so dass eine dauerhaft stabile elektrisch leitfähige Verbindung zwischen Anschlusselement und Anschlusskabel entsteht. Das Crimpen erfolgt mit einem geeigneten, dem Fachmann an sich bekannten Crimpwerkzeug, beispielsweise einer Crimpzange oder einer Crimppresse. Das Crimpwerkzeug umfasst üblicherweise zwei Wirkstellen, beispielsweise die Backen einer Crimpzange, welche gegeneinander geführt werden, wodurch ein mechanischer Druck auf das Anschlusselement ausgeübt wird. Das Anschlusselement wird dadurch plastisch verformt und um das Anschlusselement gequetscht.

Die Materialstärke des Anschlusselements beträgt bevorzugt von 0,1 mm bis 2 mm, besonders bevorzugt von 0,2 mm bis 1 mm, ganz besonders bevorzugt von 0,3 mm bis 0,5 mm. In diesem Bereich für die Materialstärke weist das Anschlusselement einerseits die zum Crimpen notwendige Kaltumformbarkeit auf. Andererseits wird in diesem Bereich für die Materialstärke eine vorteilhafte Stabilität der Crimpverbindung und eine vorteilhafte elektrische Verbindung zwischen elektrisch leitfähiger Struktur und Anschlusskabel erreicht.

Das Anschlusselement weist erfindungsgemäß einen um das Anschlusskabel gecrimpten Bereich auf. Das Anschlusselement muss aber keine weiteren Bereiche neben dem gecrimpten Bereich aufweisen, sondern kann aus dem gecrimpten Bereich bestehen.

In einer vorteilhaften Ausgestaltung ist das Anschlusselement über seine gesamte Länge um den elektrisch leitfähigen Kern des Anschlusskabels gecrimpt. Das Anschlusselement ist dann insgesamt als Crimp ausgeführt und besteht nur aus dem erfindungsgemäßen gecrimpten Bereich, was im Hinblick auf die Materialersparnis vorteilhaft ist. Das Anschlusselement kann aber neben dem um den elektrisch leitfähigen Kern gecrimpten Abschnitt (dem sogenannten Drahtcrimp oder Adercrimp) einen oder mehrere weitere Abschnitte aufweisen. Ein solcher weiterer Abschnitt kann beispielweise um die isolierende Ummantelung des Anschlusskabels gecrimpt sein (Isolationscrimp), wodurch eine stabilere Verbindung zwischen Anschlusselement und Anschlusskabel erreicht werden kann. Das Anschlusselement kann auch beispielsweise kurze Endabschnitte aufweisen, welche nicht von der Crimpung betroffen sind.

Erfindungsgemäß ist der gecrimpte Bereich des Anschlusselements über die Lotmasse mit der elektrisch leitfähigen Struktur verbunden. Gemeint ist hier eine direkte, mechanische Verbindung zwischen dem gecrimpten Bereich des Anschlusselements und der elektrisch leitfähigen Struktur über die Lotmasse. Das bedeutet, dass Lotmasse zwischen dem Crimp und der elektrisch leitfähigen Struktur angeordnet ist und dadurch den Crimp dauerhaft stabil auf der elektrisch leitfähigen Struktur fixiert. Bevorzugt ist der gesamte gecrimpte Bereich des Anschlusselements über die Lotmasse mit der elektrisch leitfähigen Struktur verbunden. Das bedeutet, dass Lotmasse entlang der gesamten Länge des Crimps zwischen dem Crimp und der elektrisch leitfähigen Struktur angeordnet ist. Dadurch wird eine besonders stabile Haftung des Anschlusselements an der elektrisch leitfähigen Struktur erreicht. Prinzipiell kann die Lotmasse aber auch nur zwischen einem Abschnitt des Crimps und der elektrisch leitfähigen Struktur angeordnet sein.

Die Lotmasse verbindet den gecrimpten Bereich des Anschlusselements mit der elektrisch leitfähigen Struktur auf dem Substrat. Erfindungsgemäß steht die Lotmasse nicht in direktem Kontakt zum elektrisch leitfähigen Kern des Anschlusskabels.

Das Anschlusselement ist als offener Crimp ausgebildet. Bei einem offenen Crimp wird das Anschlusselement als planes oder als zu einer Crimpkralle vorgebogenes Plättchen bereitgestellt. Die seitlichen Kanten des Anschlusselements werden dann um das Anschlusskabel herumgebogen. Bei einem geschlossenen Crimp ist das Anschlusselement als rundum geschlossene Hülse (Aderendhülse) ausgebildet, in welche das Anschlusskabel eingeführt wird und welche anschließend durch Quetschen verformt wird.

Crimpverbindungen können im Querschnitt senkrecht zur Ausdehnungsrichtung des Anschlusskabels eine Vielzahl von Formen aufweisen. Die Form der Crimpung wird durch die Wahl des Crimpwerkzeugs bestimmt. Ein geschlossener Crimp kann beispielsweise einen ovalen (Oval-Crimp) oder polygonalen (beispielsweise Vierkant-Crimp, Sechskant-Crimp oder Trapezcrimp) Querschnitt aufweisen. Eine der Wirkstellen des Crimpwerkzeugs kann auch eine charakteristische Quetschstruktur erzeugen, wobei der Quetschstruktur gegenüberliegend typischerweise der sogenannte Crimpboden angeordnet ist. Die Form der Crimpung wird typischerweise nach der charakteristischen Quetschstruktur benannt. Formen für einen geschlossenen Crimp sind dem Fachmann beispielsweise als W-Crimp oder Dorn-Crimp bekannt. Bei einem offenen Crimp sind die beiden um das Anschlusskabel herumgebogenen Seitenkanten des Anschlusselements mit einer charakteristischen Quetschstruktur miteinander und mit dem Anschlusskabel verquetscht. Formen für einen offenen Crimp sind dem Fachmann beispielsweise als B-Crimp (oder F-Crimp), Ü-Crimp (oder OVL-Crimp) oder O-Crimp bekannt.

Erfindungsgemäß ist der Crimp als offener Crimp ausgebildet. Da das Anschlusskabel dabei nicht in eine rundum geschlossene Aderendhülse eingesteckt werden muss, ist eine solche Crimpverbindung leichter herzustellen und leichter automatisierbar und eignet sich daher besonders für eine Massenfertigung.

Erfindungsgemäß ist der Crimp als B-Crimp ausgestaltet. Vorzugsweise ist der Innenleiter des Anschlusskabels als Drahtlitzenleiter ausgeführt. Die Einzellitzen des Drahtlitzenleiters weichen dabei durch die Symmetrie der Kontaktform gleichmäßig auf beide Seiten des Kontaktinnenraums aus, was zu einer vorteilhaften Stabilität und Gasdichtheit des Crimpkontakts führt.

Die Crimpbreite kann vom Fachmann unter Berücksichtigung des Durchmessers des Anschlusskabels sowie gängiger Normen geeignet gewählt werden und beträgt beispielsweise von 1 mm bis 5 mm oder von 2 mm bis 3 mm, insbesondere 2,5 mm. Das ist besonders vorteilhaft im Hinblick auf einen geringen Platzbedarf des Anschlusselements und eine stabile Verbindung zwischen Anschlusselement und Anschlusskabel.

Die Länge des Crimps kann vom Fachmann unter Berücksichtigung des Durchmessers des Anschlusskabels sowie gängiger Normen geeignet gewählt werden und beträgt beispielsweise von 2 mm bis 8 mm oder von 4 mm bis 5 mm, insbesondere 4,3 mm bis 4,7 mm, ganz besonders bevorzugt 4,5 mm. Das ist besonders vorteilhaft im Hinblick auf einen geringen Platzbedarf des Anschlusselements und eine stabile Verbindung zwischen Anschlusselement und Anschlusskabel.

Die Crimphöhe richtet sich nach dem Durchmesser des Anschlusskabels und kann vom Fachmann unter Berücksichtigung gängiger Normen geeignet gewählt werden.

Das Substrat weist einen ersten thermischen Ausdehnungskoeffizienten auf. Das Anschlusselement weist einen zweiten thermischen Ausdehnungskoeffizienten auf. In einer vorteilhaften Ausgestaltung der Erfindung ist die Differenz zwischen dem ersten und dem zweiten Ausdehnungskoeffizienten kleiner 5 x 10⁻⁶/°C, besonders bevorzugt kleiner 3 x 10⁻⁶/°C. Dadurch werden die thermischen Spannungen der Scheibe reduziert und eine bessere Haftung erreicht.

Das Substrat enthält bevorzugt Glas, besonders bevorzugt Flachglas, Floatglas, Quarzglas, Borosilikatglas und / oder Kalk-Natron-Glas. Das Substrat kann aber auch Polymere enthalten, bevorzugt Polyethylen, Polypropylen, Polycarbonat, Polymethylmethacrylat, Polystyrol, Polybutadien, Polynitrile, Polyester, Polyurethan, Polyvinylchlorid, Polyacrylat, Polyamid, Polyethylenterephthalat und / oder Copolymere oder Gemische davon. Das Substrat ist bevorzugt transparent. Das Substrat weist bevorzugt eine Dicke von 0,5 mm bis 25 mm, besonders bevorzugt von 1 mm bis 10 mm und ganz besonders bevorzugt von 1,5 mm bis 5 mm auf.

Der erste thermische Ausdehnungskoeffizient beträgt bevorzugt von 8 x 10⁻⁶/°C bis 9 x 10⁻⁶/°C. Das Substrat enthält bevorzugt Glas, das bevorzugt einen thermischen Ausdehnungskoeffizienten von 8,3 x 10⁻⁶/°C bis 9 x 10⁻⁶/°C in einem Temperaturbereich von 0 °C bis 300 °C aufweist.

Der zweite thermische Ausdehnungskoeffizient ist bevorzugt von 9 x 10⁻⁶/°C bis 13 x 10⁻⁶/°C, besonders bevorzugt von 10 x 10⁻⁶/°C bis 11,5 x 10⁻⁶/°C, ganz besonders bevorzugt von 10 x 10⁻⁶/°C bis 11 x 10⁻⁶/°C und insbesondere von 10 x 10⁻⁶/°C bis 10,5 x 10⁻⁶/°C in einem Temperaturbereich von 0 °C bis 300 °C.

Das erfindungsgemäße Anschlusselement enthält bevorzugt einen chromhaltigen Stahl mit einem Anteil an Chrom von größer oder gleich 10,5 Gew.-%. Weitere Legierungsbestandteile wie Molybdän, Mangan oder Niob führen zu einer verbesserten Korrosionsbeständigkeit oder veränderten mechanischen Eigenschaften, wie Zugfestigkeit oder Kaltumformbarkeit.

Das erfindungsgemäße Anschlusselement enthält bevorzugt zumindest 66,5 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän, 0 Gew.-% bis 2 Gew.-% Niob und 0 Gew.-% bis 1 Gew.-% Titan. Das Anschlusselement kann zusätzlich Beimengungen weiterer Elemente enthalten, darunter Vanadium, Aluminium und Stickstoff.

Das erfindungsgemäße Anschlusselement enthält besonders bevorzugt zumindest 73 Gew.-% bis 89,5 Gew.-% Eisen, 10,5 Gew.-% bis 20 Gew.-% Chrom, 0 Gew.-% bis 0,5 Gew.-% Kohlenstoff, 0 Gew.-% bis 2,5 Gew.-% Nickel, 0 Gew.-% bis 1 Gew.-% Mangan, 0 Gew.-% bis 1,5 Gew.-% Molybdän, 0 Gew.-% bis 1 Gew.-% Niob und 0 Gew.-% bis 1 Gew.-% Titan. Das Anschlusselement kann zusätzlich Beimengungen weiterer Elemente enthalten, darunter Vanadium, Aluminium und Stickstoff.

Das erfindungsgemäße Anschlusselement enthält ganz besonders bevorzugt zumindest 77 Gew.-% bis 84 Gew.-% Eisen, 16 Gew.-% bis 18,5 Gew.-% Chrom, 0 Gew.-% bis 0,1 Gew.-% Kohlenstoff, 0 Gew.-% bis 1 Gew.-% Mangan, 0 Gew.-% bis 1 Gew.-% Niob, 0 Gew.-% bis 1,5 Gew.-% Molybdän und 0 Gew.-% bis 1 Gew.-% Titan. Das Anschlusselement kann zusätzlich Beimengungen weiterer Elemente enthalten, darunter Vanadium, Aluminium und Stickstoff.

Besonders geeignete chromhaltige Stähle sind Stähle der Werkstoffnummern 1.4016, 1.4113, 1.4509 und 1.4510 nach EN 10 088-2.

Die erfindungsgemäße elektrisch leitfähige Struktur weist bevorzugt eine Schichtdicke von 5 µm bis 40 µm, besonders bevorzugt von 5 µm bis 20 µm, ganz besonders bevorzugt von 8 µm bis 15 µm und insbesondere von 10 µm bis 12 µm auf. Die erfindungsgemäße elektrisch leitfähige Struktur enthält bevorzugt Silber, besonders bevorzugt Silberpartikel und Glasfritten.

Die Schichtdicke der Lotmasse ist bevorzugt kleiner oder gleich 6.0 x 10⁻⁴ m, besonders bevorzugt kleiner 3.0 x 10⁻⁴ m.

Die Lotmasse ist bevorzugt bleifrei. Das ist besonders vorteilhaft im Hinblick auf die Umweltverträglichkeit der erfindungsgemäßen Scheibe mit elektrischem Anschlusselement. Als bleifreie Lotmasse ist im Sinne der Erfindung eine Lotmasse zu verstehen, welche entsprechend der EG-Richtlinie "2002/95/EG zur Beschränkung der Verwendung bestimmter gefährlicher Stoffe in Elektro- und Elektronikgeräten" einen Anteil von kleiner oder gleich 0,1 Gew.-% Blei, bevorzugt kein Blei enthält.

Bleifreie Lotmassen weisen typischerweise eine geringere Duktilität auf als bleihaltige Lotmassen, so dass mechanische Spannungen zwischen Anschlusselement und Scheibe weniger gut kompensiert werden können. Es hat sich aber gezeigt, dass kritische mechanische Spannungen durch das erfindungsgemäße Anschlusselement vermieden werden können. Die Lotmasse enthält bevorzugt Zinn und Wismut, Indium, Zink, Kupfer, Silber oder Zusammensetzungen davon. Der Anteil an Zinn in der erfindungsgemäßen Lotzusammensetzung beträgt von 3 Gew.-% bis 99,5 Gew.-%, bevorzugt von 10 Gew.-% bis 95,5 Gew.-%, besonders bevorzugt von 15 Gew.-% bis 60 Gew.-%. Der Anteil an Wismut, Indium, Zink, Kupfer, Silber oder Zusammensetzungen davon beträgt in der erfindungsgemäßen Lotzusammensetzung von 0,5 Gew.-% bis 97 Gew.-%, bevorzugt 10 Gew.-% bis 67 Gew.-%, wobei der Anteil an Wismut, Indium, Zink, Kupfer oder Silber 0 Gew.-% betragen kann. Die erfindungsgemäße Lotzusammensetzung kann Nickel, Germanium, Aluminium oder Phosphor mit einem Anteil von 0 Gew.-% bis 5 Gew.-% enthalten. Die erfindungsgemäße Lotzusammensetzung enthält ganz besonders bevorzugt Bi40Sn57Ag3, Sn40Bi57Ag3, Bi59Sn40Ag1, Bi57Sn42Ag1, In97Ag3, Sn95,5Ag3,8Cu0,7, Bi67In33, Bi33In50Sn17, Sn77,2In20Ag2,8, Sn95Ag4Cu1, Sn99Cu1, Sn96,5Ag3,5, Sn96,5Ag3Cu0,5, Sn97Ag3 oder Gemische davon.

In einer vorteilhaften Ausgestaltung enthält die Lotmasse Wismut. Es hat sich gezeigt, dass eine Wismut-haltige Lotmasse zu einer besonders guten Haftung des erfindungsgemäßen Anschlusselements an der Scheibe führt, wobei Beschädigungen der Scheibe vermieden werden können. Der Anteil des Wismuts an der Lotmassenzusammensetzung beträgt bevorzugt von 0,5 Gew.-% bis 97 Gew.-%, besonders bevorzugt von 10 Gew.-% bis 67 Gew.-% und ganz besonders bevorzugt von 33 Gew.-% bis 67 Gew.-%, insbesondere von 50 Gew.-% bis 60 Gew.-%. Die Lotmasse enthält neben Wismut bevorzugt Zinn und Silber oder Zinn, Silber und Kupfer. In einer besonders bevorzugten Ausgestaltung enthält die Lotmasse zumindest 35 Gew.-% bis 69 Gew.-% Wismut, 30 Gew.-% bis 50 Gew.-% Zinn, 1 Gew.-% bis 10 Gew.-% Silber und 0 Gew.-% bis 5 Gew.-% Kupfer. In einer ganz besonders bevorzugten Ausgestaltung enthält die Lotmasse zumindest 49 Gew.-% bis 60 Gew.-% Wismut, 39 Gew.-% bis 42 Gew.-% Zinn, 1 Gew.-% bis 4 Gew.-% Silber und 0 Gew.-% bis 3 Gew.-% Kupfer.

In einer weiteren vorteilhaften Ausgestaltung enthält die Lotmasse von 90 Gew.-% bis 99,5 Gew.-% Zinn, bevorzugt von 95 Gew.-% bis 99 Gew.-%, besonders bevorzugt von 93 Gew.-% bis 98 Gew.-%. Die Lotmasse enthält neben Zinn bevorzugt von 0,5 Gew.-% bis 5 Gew.-% Silber und von 0 Gew.-% bis 5 Gew.-% Kupfer.

Die Lotmasse tritt mit einer Austrittsbreite von bevorzugt kleiner 1 mm aus dem Zwischenraum zwischen dem Anschlusselement und der elektrisch leitfähigen Struktur aus. In einer bevorzugten Ausgestaltung ist die maximale Austrittsbreite kleiner 0,5 mm und insbesondere etwa 0 mm. Das ist besonders vorteilhaft im Hinblick auf die Reduzierung von mechanischen Spannungen in der Scheibe, die Haftung des Anschlusselements und die Einsparung des Lots. Die maximale Austrittsbreite ist definiert als der Abstand zwischen den Außenkanten des Anschlusselementes und der Stelle des Lotmasseübertritts, an dem die Lotmasse eine Schichtdicke von 50 µm unterschreitet. Die maximale Austrittsbreite wird nach dem Lötvorgang an der erstarrten Lotmasse gemessen. Eine gewünschte maximale Austrittsbreite wird durch eine geeignete Wahl von Lotmassenvolumen und lotrechtem Abstand zwischen Anschlusselement und elektrisch leitfähiger Struktur erreicht, was durch einfache Versuche ermittelt werden kann. Der lotrechte Abstand zwischen Anschlusselement und elektrisch leitfähiger Struktur kann durch ein entsprechendes Prozesswerkzeug, beispielsweise ein Werkzeug mit einem integrierten Abstandshalter, vorgegeben werden. Die maximale Austrittsbreite kann auch negativ sein, also in den von elektrischem Anschlusselement und elektrisch leitfähiger Struktur gebildeten Zwischenraum zurückgezogen sein. In einer vorteilhaften Ausgestaltung der erfindungsgemäßen Scheibe ist die maximale Austrittsbreite in dem vom elektrischen Anschlusselement und der elektrisch leitfähigen Struktur gebildeten Zwischenraum in einem konkaven Meniskus zurückgezogen. Ein konkaver Meniskus entsteht beispielsweise durch Erhöhen des lotrechten Abstands zwischen Abstandshalter und leitfähiger Struktur beim Lötvorgang, während das Lot noch flüssig ist. Der Vorteil liegt in der Reduzierung der mechanischen Spannungen in der Scheibe, insbesondere im kritischen Bereich, der bei einem großen Lotmasseübertritt vorliegt.

In einer vorteilhaften Ausgestaltung der Erfindung weist das Anschlusselement Abstandshalter auf, bevorzugt mindestens zwei Abstandshalter, besonders bevorzugt mindestens drei Abstandshalter. Die Abstandshalter sind auf der Kontaktfläche zwischen Anschlusselement und Lotmasse angeordnet und bevorzugt einstückig mit dem Anschlusselement ausgebildet, beispielsweise durch Prägen oder Tiefziehen. Die Abstandshalter haben bevorzugt eine Breite von 0,5 x 10⁻⁴ m bis 10 x 10⁻⁴ m und eine Höhe von 0,5 x 10⁻⁴ m bis 5 x 10⁻⁴ m, besonders bevorzugt von 1 x 10⁻⁴ m bis 3 x 10⁻⁴ m. Durch die Abstandshalter wird eine homogene, gleichmäßig dicke und gleichmäßig aufgeschmolzene Schicht der Lotmasse erreicht. Dadurch können mechanische Spannungen zwischen Anschlusselement und Scheibe verringert werden und die Haftung des Anschlusselements verbessert werden. Das ist insbesondere bei der Verwendung bleifreier Lotmassen besonders vorteilhaft, die aufgrund ihrer geringeren Duktilität im Vergleich zu bleihaltigen Lotmassen mechanische Spannungen weniger gut kompensieren können.

In einer vorteilhaften Ausgestaltung der Erfindung sind auf der vom Substrat abgewandten Seite des Anschlusselements eine oder mehrere Kontakterhebungen angeordnet, welche der Kontaktierung des Anschlusselements mit den Lötwerkzeugen während des Lötvorgangs dienen. Jede Kontakterhebung ist bevorzugt zumindest im Bereich der Kontaktierung mit dem Lötwerkzeug konvex gekrümmt ausgeformt. Die Kontakterhebungen haben bevorzugt eine Höhe von 0,1 mm bis 2 mm, besonders bevorzugt von 0,2 mm bis 1 mm. Die Länge und Breite der Kontakterhebungen beträgt bevorzugt zwischen 0,1 und 5 mm, ganz besonders bevorzugt zwischen 0,4 mm und 3 mm. Die Kontakterhebungen sind bevorzugt einstückig mit dem Anschlusselement ausgebildet, beispielsweise durch Prägen oder Tiefziehen. Zum Löten können Elektroden verwendet werden, deren Kontaktseite flach ausgeformt ist. Die Elektrodenfläche wird mit der Kontakterhebung in Kontakt gebracht. Die Elektrodenfläche ist dabei parallel zur Oberfläche des Substrats angeordnet. Der Kontaktbereich zwischen Elektrodenfläche und Kontakterhebung bildet die Lötstelle. Die Position der Lötstelle wird dabei durch den Punkt auf der konvexen Oberfläche der Kontakterhebung bestimmt, der den größten lotrechten Abstand zur Oberfläche des Substrats aufweist. Die Position der Lötstelle ist unabhängig von der Position der Lötelektrode auf dem Anschlusselement. Das ist besonders vorteilhaft im Hinblick auf eine reproduzierbare, gleichmäßige Wärmeverteilung während des Lötvorgangs. Die Wärmeverteilung während des Lötvorgangs wird durch die Position, die Größe, die Anordnung und die Geometrie der Kontakterhebung bestimmt.

Das elektrische Anschlusselement weist bevorzugt zumindest auf der zur Lotmasse ausgerichteten Fläche eine Beschichtung auf, die Kupfer, Zink, Zinn, Silber, Gold oder Legierungen oder Schichten davon, bevorzugt Silber enthält. Dadurch wird eine verbesserte Benetzung des Anschlusselements mit der Lotmasse und eine verbesserte Haftung des Anschlusselements erreicht.

Das erfindungsgemäße Anschlusselement ist bevorzugt mit Nickel, Zinn, Kupfer und / oder Silber beschichtet. Das erfindungsgemäße Anschlusselement ist besonders bevorzugt mit einer haftvermittelnden Schicht, bevorzugt aus Nickel und / oder Kupfer, und zusätzlich mit einer lötbaren Schicht, bevorzugt aus Silber, versehen. Das erfindungsgemäße Anschlusselement ist ganz besonders bevorzugt mit 0,1 µm bis 0,3 µm Nickel und / oder 3 µm bis 20 µm Silber beschichtet. Das Anschlusselement kann vernickelt, verzinnt, verkupfert und / oder versilbert werden. Nickel und Silber verbessern die Stromtragfähigkeit und Korrosionsstabilität des Anschlusselements und die Benetzung mit der Lotmasse.

Die Form des elektrischen Anschlusselementes kann ein oder mehrere Lotdepots im Zwischenraum von Anschlusselement und elektrisch leitfähiger Struktur ausbilden. Die Lotdepots und Benetzungseigenschaften des Lotes am Anschlusselement verhindern den Austritt der Lotmasse aus dem Zwischenraum. Lotdepots können rechtwinklig, verrundet oder polygonal ausgestaltet sein.

Die Erfindung umfasst weiter die Verwendung der erfindungsgemäßen Scheibe in Gebäuden oder in Fortbewegungsmitteln für den Verkehr auf dem Lande, in der Luft oder zu Wasser, insbesondere in Schienenfahrzeugen oder Kraftfahrzeugen, bevorzugt als Windschutzscheibe, Heckscheibe, Seitenscheibe und / oder Dachscheibe, insbesondere als beheizbare Scheibe oder als Scheibe mit Antennenfunktion.

Die Erfindung wird anhand einer Zeichnung und Ausführungsbeispielen näher erläutert.. Die Zeichnung ist eine schematische Darstellung und nicht maßstabsgetreu. Die Zeichnung schränkt die Erfindung in keiner Weise ein. Es zeigen:
- Fig. 1: eine Draufsicht auf eine erste Ausgestaltung der erfindungsgemäßen Scheibe,
- Fig. 2: einen Schnitt A-A' durch die Scheibe gemäß Figur 1,
- Fig. 3: einen Schnitt B-B' durch die Scheibe gemäß Figur 1,
- Fig. 4: einen Schnitt A-A' durch eine alternative erfindungsgemäße Scheibe,
- Fig. 5: einen Schnitt A-A' durch eine weitere alternative erfindungsgemäße Scheibe,
- Fig. 6: einen Schnitt A-A' durch eine weitere alternative erfindungsgemäße Scheibe,
- Fig. 7: einen Schnitt B-B' durch eine weitere Scheibe, welche nicht Teil der Erfindung ist,
- Fig. 8: einen Schnitt B-B' durch eine weitere Scheibe, welche nicht Teil der Erfindung ist,
- Fig. 8a: einen Schnitt B-B' durch eine weitere Scheibe, welche nicht Teil der Erfindung ist,
- Fig. 9: einen Schnitt B-B' durch weitere alternative Anschlusselemente, welche nicht Teil der Erfindung sind,
- Fig. 10: ein detailliertes Flussdiagramm eines Verfahrens zur Herstellung der erfindungsgemäßen Scheibe.

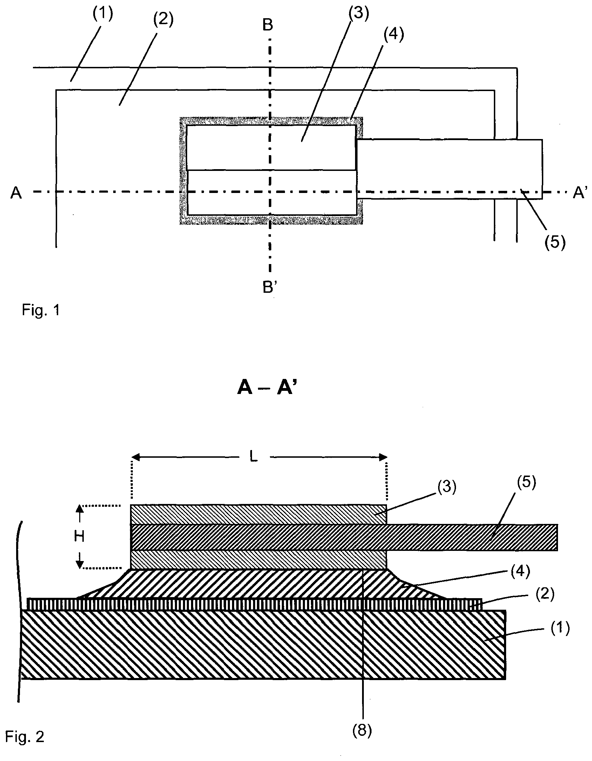

Fig.1, Fig. 2 und Fig. 3 zeigen je ein Detail einer erfindungsgemäßen Scheibe im Bereich des elektrischen Anschlusselements 3. Die Scheibe umfasst ein Substrat 1, welches ein 3 mm dickes thermisch vorgespanntes Einscheibensicherheitsglas aus Natron-Kalk-Glas ist. Das Substrat 1 weist eine Breite von 150 cm und eine Höhe von 80 cm auf. Auf das Substrat 1 ist eine elektrisch leitfähige Struktur 2 in Form einer Heizleiterstruktur aufgedruckt. Die elektrisch leitfähige Struktur 2 enthält Silberpartikel und Glasfritten. Im Randbereich der Scheibe ist die elektrisch leitfähige Struktur 2 auf eine Breite von 10 mm verbreitert und bildet eine Kontaktfläche für das elektrische Anschlusselement 3. Im Randbereich des Substrats 1 befindet sich weiter ein nicht dargestellter Abdecksiebdruck. Im Bereich der Kontaktfläche 8 zwischen dem elektrischen Anschlusselement 3 und der elektrisch leitfähigen Struktur 2 ist Lotmasse 4 aufgebracht, die eine dauerhafte elektrische und mechanische Verbindung zwischen dem elektrischen Anschlusselement 3 und der elektrisch leitfähigen Struktur 2 bewirkt. Die Lotmasse 4 enthält 57 Gew.-% Wismut, 40 Gew.-% Zinn und 3 Gew.-% Silber. Die Lotmasse 4 hat eine Dicke von 250 µm.

Das elektrische Anschlusselement 3 besteht aus Stahl der Werkstoff-Nummer 1.4509 nach EN 10 088-2 (ThyssenKrupp Nirosta® 4509) mit einem thermischen Ausdehnungskoeffizienten von 10,5 x 10⁻⁶/°C im Temperaturbereich von 20°C bis 300°C. Das Anschlusselement 3 ist entlang seiner gesamten Länge um den Endbereich eines Anschlusskabels 5 gecrimpt. Das Anschlusselement 3 ist also insgesamt als Crimp ausgebildet. Das Anschlusskabel 5 enthält einen elektrisch leitfähigen Kern, welcher als herkömmlicher Drahtlitzenleiter ausgebildet ist. Das Anschlusskabel 5 enthält weiter eine nicht dargestellte polymere Isolierummantelung, welche im Endbereich entfernt ist, um die elektrische Kontaktierung des elektrisch leitfähigen Kerns des Anschlusskabels 5 mit dem Anschlusselement 3 zu ermöglichen. Die Länge des abisolierten Bereichs übersteigt die Länge L des Crimps um beispielsweise 0,5 mm bis 3 mm, um die Biegbarkeit des Anschlusskabels 5 zu gewährleisten.

Das Anschlusselement 3 ist als offener Crimp ausgebildet. Das Anschlusselement 3 wurde dazu bei der Herstellung der Scheibe als Plättchen mit einer Materialstärke von beispielsweise 0,4 mm bereitgestellt, welches mittels eines Crimpwerkzeugs um das Anschlusskabel 5 herumgebogen und durch Quetschen (Crimpen) dauerhaft stabil mit dem Anschlusskabel 5 verbunden wurde. Die Länge des Anschlusselements 3 entspricht der Länge L des Crimps (Crimplänge) und beträgt etwa 4,5 mm, die Breite des Anschlusselements 3 (Crimpbreite B) beträgt etwa 2,5 mm.

Das Anschlusselement 3 weist die Form eines B-Crimps auf. Die seitlichen Kanten des Anschlusselements 3 sind dabei um das Anschlusskabel 5 herumgebogen und durch "Einstechen" des Crimpwerkzeugs im elektrisch leitfähigen Kern des Anschlusskabels 5 versenkt, wobei die (nicht einzeln dargestellten) Drahtlitzen des Anschlusskabels 5 gleichmäßig auf beide Seiten in den Kontaktinnenraum ausweichen. Die charakteristische Quetschform zeigt im Profil zwei abgerundete Strukturen nach Art des Buchstabens "B". Die charakteristische Quetschform ist an der vom Substrat 1 abgewandten Oberseite des Anschlusselements 3 angeordnet. Die Kontaktfläche 8 zwischen Anschlusselement 3 und Lotmasse 4 ist der charakteristischen Quetschform gegenüberliegend (also am Crimpboden) angeordnet. So wird eine vorteilhafte Benetzung des Anschlusselements 3 mit der Lotmasse 4 erreicht.

Der Crimpboden weist in der dargestellten Ausgestaltung einen planen Abschnitt auf, welcher den wesentlichen Teil der Kontaktfläche 8 ausmacht. Der Crimpboden kann aber auch insgesamt plan oder gewölbt ausgestaltet sein. Der Crimpboden wie in der dargestellten glatt ausgebildet sein. Der Crimpboden kann aber auch eine Gratbildung aufweisen, wie dies in der Crimptechnik üblich ist. Die Grate sind bevorzugt symmetrisch in den seitlichen Randbereichen des Crimpbodens ausgebildet.

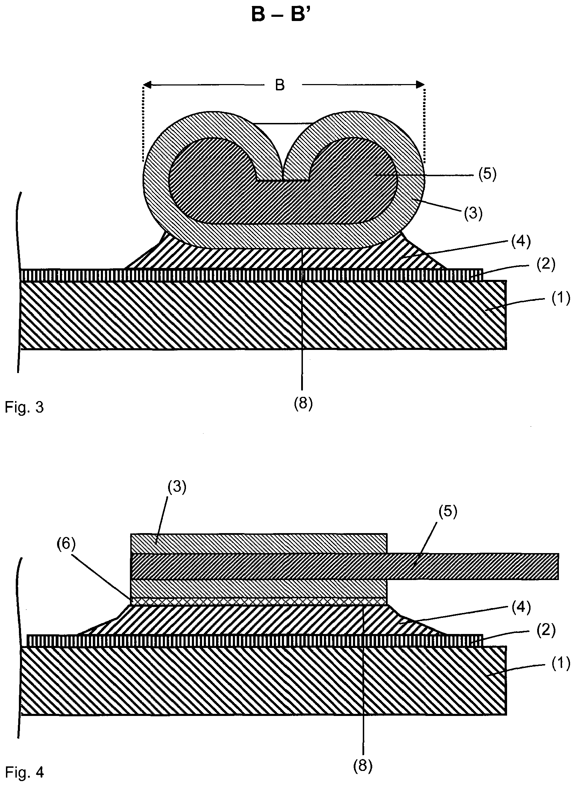

Fig. 4 zeigt einen Querschnitt entlang A-A' durch eine alternative Ausgestaltung der erfindungsgemäßen Scheibe mit dem als B-Crimp ausgebildeten Anschlusselement 3. Das Anschlusselement 3 ist auf der zur Lotmasse 4 hin ausgerichteten Fläche mit einer silberhaltigen Benetzungsschicht 6 versehen, beispielsweise mit einer Dicke von etwa 5 µm. Dadurch wird die Haftung des Anschlusselements 3 verbessert. In einer weiteren Ausgestaltung kann sich zwischen Anschlusselement 3 und Benetzungsschicht 6 eine haftvermittelnde Schicht, beispielsweise aus Nickel und / oder Kupfer, befinden.

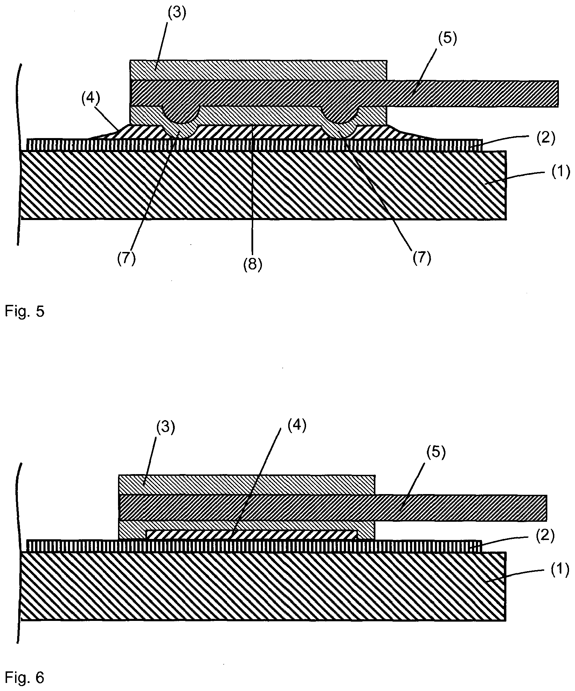

Fig. 5 zeigt einen Querschnitt entlang A-A' durch eine alternative Ausgestaltung der erfindungsgemäßen Scheibe mit dem als B-Crimp ausgebildeten Anschlusselement 3. Am Crimpboden an der zum Substrat 1 hingewandten Seite des Anschlusselements 3 sind Abstandshalter 7 angeordnet. Es können beispielsweise vier Abstandshalter 7 auf der Kontaktfläche 8 angeordnet sein, von denen im dargestellten Schnitt zwei Abstandshalter 7 zu erkennen ist. Die Abstandshalter 7 sind in das Anschlusselement 3 eingeprägt und somit einstückig mit dem Anschlusselement 3 ausgebildet. Die Abstandshalter sind als Kugelsegment ausgeformt und haben eine Höhe von 2,5 x 10⁻⁴ m und eine Breite von 5 x 10⁻⁴ m. Durch die Abstandshalter 7 wird die Ausbildung einer gleichmäßigen Schicht der Lotmasse 4 begünstigt. Das ist besonders vorteilhaft in Hinblick auf die Haftung des Anschlusselements 3.

Fig. 6 zeigt einen Querschnitt entlang A-A' durch eine alternative Ausgestaltung der erfindungsgemäßen Scheibe mit dem als B-Crimp ausgebildeten Anschlusselement 3. Das elektrische Anschlusselement 3 enthält auf der zur Lotmasse 4 hin ausgerichteten Fläche am Crimpboden eine Aussparung mit einer Tiefe von 250 µm, die ein Lotdepot für die Lotmasse 4 bildet. Ein Austritt der Lotmasse 4 aus dem Zwischenraum kann vollständig verhindert werden. Dadurch werden die thermischen Spannungen in der Scheibe weiter reduziert. Das Lotdepot kann auch in das Anschlusselement 3 eingeprägt sein.

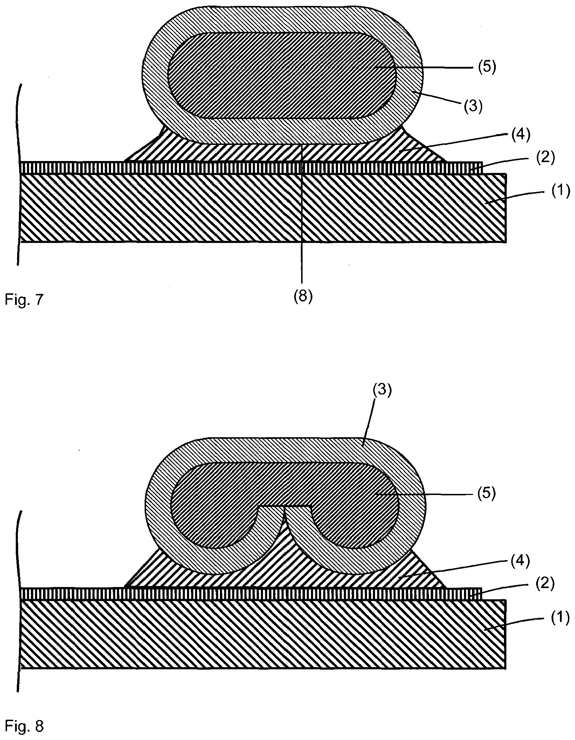

Fig. 7 zeigt einen Querschnitt entlang B-B' durch eine alternative Ausgestaltung der Scheibe, welche nicht Teil der Erfindung ist. Das Anschlusselement 3 ist als geschlossener Crimp ausgestaltet. Das Anschlusselement 3 wurde als rundum geschlossene Hülse (Aderendhülse) bereitgestellt, in die der abisolierte Endbereich des Anschlusskabels 5 eingesteckt wurde. Das Anschlusselement 3 wurde anschließend durch Quetschen (Crimpen) in der Art eines Oval-Crimps dauerhaft stabil mit dem Anschlusskabel 5 verbunden.

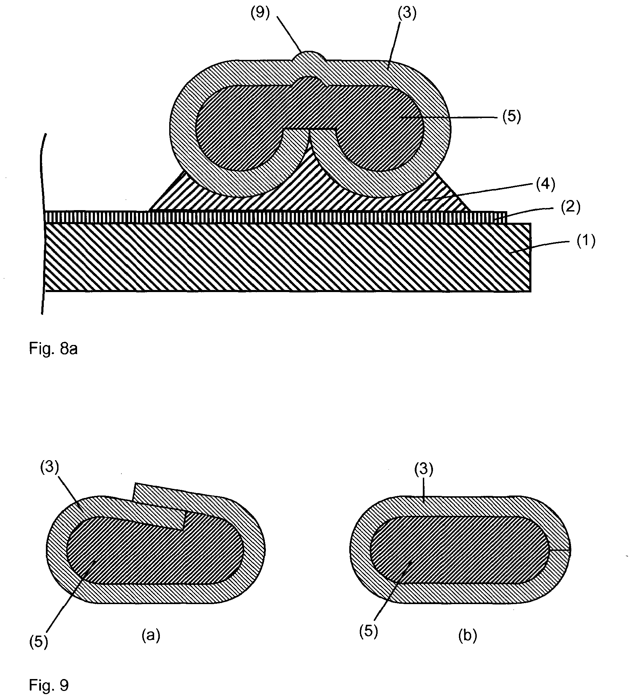

Fig. 8 zeigt einen Querschnitt entlang B-B' durch eine alternative Ausgestaltung der Scheibe, welche nicht Teil der Erfindung ist. Das Anschlusselement 3 ist als offener B-Crimp wie in Figur 3 ausgestaltet. Im Unterschied zu der Ausgestaltung aus Figur 3 ist das Anschlusselement 3 so auf der Scheibe angeordnet, dass der Crimpboden vom Substrat 1 abgewandt ist und die charakteristische Quetschstruktur zum Substrat 1 hingewandt und über die Lotmasse 4 mit der elektrisch leitfähigen Struktur 2 verbunden ist. Ein Vorteil dieser Anordnung des Anschlusselements 3 ist, dass die abgerundeten Bereiche der charakteristischen Quetschstruktur als Abstandshalter dienen können, wodurch auf einfache Weise ein definierter Abstand des Anschlusselements 3 zur elektrisch leitfähigen Struktur 2 erreicht wird. Zudem hat sich gezeigt, dass die abgerundeten Bereiche zu einer vorteilhaften Verteilung der Lotmasse 4 (Ausbildung einer vorteilhaften Lötkehle) führen.

Fig. 8a zeigt einen Querschnitt durch eine alternative Ausgestaltung der Scheibe mit dem Anschlusselement 3, welche nicht Teil der Erfindung ist. Das Anschlusselement 3 ist als offener B-Crimp ausgebildet, wobei der der Crimpboden vom Substrat 1 abgewandt angeordnet ist. Am Crimpboden ist eine Kontakterhebung 9 zu erkennen. Die Kontakterhebung 9 ist in den Crimpboden eingeprägt und somit einstückig mit dem Anschlusselement 3 ausgebildet. Die Kontakterhebung 9 ist als Kugelsegment ausgeformt und hat eine Höhe von 2,5 x 10⁻⁴ m und eine Breite von 5 x 10⁻⁴ m. Die Kontakterhebung 9 dient der Kontaktierung des Anschlusselements 3 mit dem Lötwerkzeug während des Lötvorgangs. Durch die Kontakterhebung 9 wird eine reproduzierbare und definierte Wärmeverteilung unabhängig von der exakten Positionierung des Lötwerkzeugs sichergestellt.

Fig. 9 zeigt Querschnitte durch zwei beispielhafte weitere Ausgestaltungen des Anschlusselements 3 mit dem Anschlusskabel 5, welche nicht Teil der Erfindung sind. Die Anschlusselemente 3 sind jeweils als offener Crimp ausgebildet. In Teil (a) ist das Anschlusselement 3 als sogenannter Ü-Crimp ausgeformt. Die um das Anschlusskabel 5 herumgebogenen seitlichen Kanten des Anschlusselements 3 überlappen einander. In Teil (b) ist das Anschlusselement 3 als sogenannter O-Crimp ausgeformt. Die um das Anschlusskabel 5 herumgebogenen seitlichen Kanten des Anschlusselements 3 sind bündig gegeneinander geführt.

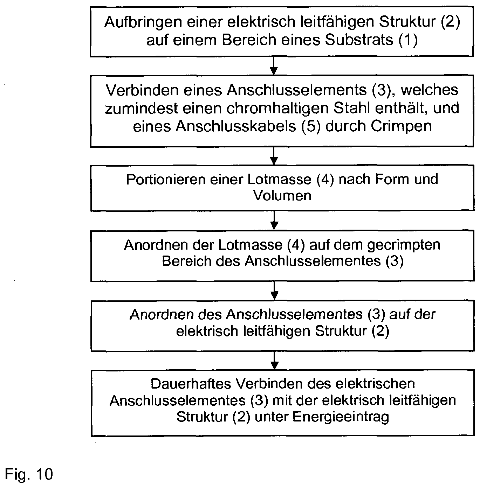

Fig. 10 zeigt detailliert ein Verfahren zur Herstellung einer erfindungsgemäßen Scheibe mit elektrischem Anschlusselement 3.

Testproben wurden angefertigt mit dem Substrat 1 (Dicke 3 mm, Breite 150 cm und Höhe 80 cm), der elektrisch leitfähigen Struktur 2 in Form einer Heizleiterstruktur, dem elektrischen Anschlusselement 3 gemäß Figur 1 und der Lotmasse 4. Das Anschlusselement 3 bestand aus Stahl der Werkstoff-Nummer 1.4509 nach EN 10 088-2, der einen thermischen Ausdehnungskoeffizienten von 10,0 x 10⁻⁶/°C im Temperaturbereich von 20°C bis 200°C und einen thermischen Ausdehnungskoeffizienten von 10,5 x 10⁻⁶/°C im Temperaturbereich von 20°C bis 300°C aufweist. Das Substrat 1 bestand aus Natron-Kalk-Glas mit einem thermischen Ausdehnungskoeffizienten von 8,30 x 10⁻⁶/°C im Temperaturbereich von 20°C bis 300°C. Die Lotmasse 4 enthielt Sn40Bi57Ag3 und wies eine Schichtdicke von 250 µm auf. Das Anschlusselement 3 wurde bei einer Temperatur von 200 °C und einer Behandlungsdauer von 2 Sekunden auf der elektrisch leitfähigen Struktur 2 angelötet. Es wurden keine kritischen mechanischen Spannungen in der Scheibe beobachtet. Die Verbindung der Scheibe mit dem elektrischen Anschlusselement 3 war über die elektrisch leitfähige Struktur 2 dauerhaft stabil. Bei sämtlichen Proben konnte bei einem Temperaturunterschied von +80 °C auf -30 °C beobachtet werden, dass kein Substrat 1 brach oder Schäden aufwies. Es konnte gezeigt werden, dass kurz nach dem Anlöten die Scheiben mit angelöteten Anschlusselement 3 gegen plötzlichen Temperaturabfall stabil waren.

In Vergleichsbeispielen mit Anschlusselementen, welche die gleiche Form aufwiesen und aus Kupfer oder Messing bestanden, traten deutlich höhere mechanische Spannungen auf und bei einem plötzlichen Temperaturunterschied von +80 °C auf -30 °C wurde beobachtet, dass die Scheiben kurz nach dem Anlöten überwiegend Schäden aufwiesen. Es hat sich gezeigt, dass erfindungsgemäße Scheiben mit Glassubstraten 1 und erfindungsgemäßen elektrischen Anschlusselementen 3 eine bessere Stabilität gegen plötzliche Temperaturunterschiede aufwiesen. Dieses Ergebnis war für den Fachmann unerwartet und überraschend.

### Bezugszeichenliste

- (1): Substrat
- (2): elektrisch leitfähige Struktur
- (3): elektrisches Anschlusselement
- (4): Lotmasse
- (5): Anschlusskabel
- (6): Benetzungsschicht
- (7): Abstandshalter
- (8): Kontaktfläche des Anschlusselements 3 mit der elektrisch leitfähigen Struktur 2
- (9): Kontakterhebung

- H: Crimphöhe
- B: Crimpbreite
- L: Crimplänge

- A-A': Schnittlinie
- B-B': Schnittlinie

## Patentansprüche

1. Eine Scheibe mit mindestens einem elektrischen Anschlusselement, mindestens umfassend:
- ein Substrat (1),
- auf einem Bereich des Substrats (1)0 eine elektrisch leitfähige Struktur (2),
- auf einem Bereich der elektrisch leitfähigen Struktur (2) ein Anschlusselement (3), das zumindest einen chromhaltigen Stahl enthält,
wobei das Anschlusselement (3) einen um ein Anschlusskabel (5) gecrimpten Bereich aufweist, wobei der gecrimpte Bereich des Anschlusselements (3) über eine Lotmasse (4) mit der elektrisch leitfähigen Struktur (2) direkt verbunden ist, wobei die Lotmasse (4) nicht in direktem Kontakt zu einem elektrisch leitfähigen Kern des Anschlusskabels (5) steht, wobei das Anschlusselement (3) als offener Crimp ausgebildet ist, wobei das Anschlusselement (3) die Form eines B-Crimps aufweist, wobei die Quetschform des B-Crimps im Profil zwei abgerundete Strukturen nach Art des Buchstabens "B" zeigt, wobei die Quetschform an einer vom Substrat (1) abgewandten Oberseite des Anschlusselements (3) angeordnet ist und die Kontaktfläche (8) der elektrisch leitfähigen Struktur (2) zwischen Anschlusselement (3) und Lotmasse (4) der Quetschform gegenüberliegend angeordnet ist.

2. Scheibe nach Anspruch 1, wobei das Anschlusskabel (5) einen Drahtlitzenleiter enthält.

3. Scheibe nach Anspruch 1 oder 2, wobei die Materialstärke des Anschlusselements (3) von 0,1 mm bis 2 mm, bevorzugt von 0,2 mm bis 1 mm, besonders bevorzugt von 0,3 mm bis 0,5 mm beträgt.

4. Scheibe nach einem der Ansprüche 1 bis 3, wobei die Differenz zwischen dem thermischen Ausdehnungskoeffizienten des Substrats (1) und dem thermischen Ausdehnungskoeffizienten des Anschlusselements (3) kleiner 5 x 10⁻⁶/°C ist.

5. Scheibe nach einem der Ansprüche 1 bis 4, wobei das Anschlusselement (3) zumindest 66,5 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän, 0 Gew.-% bis 2 Gew.-% Niob und 0 Gew.-% bis 1 Gew.-% Titan enthält.

6. Scheibe nach Anspruch 5, wobei das Anschlusselement (3) zumindest 77 Gew.-% bis 84 Gew.-% Eisen, 16 Gew.-% bis 18,5 Gew.-% Chrom, 0 Gew.-% bis 0,1 Gew.-% Kohlenstoff, 0 Gew.-% bis 1 Gew.-% Mangan, 0 Gew.-% bis 1 Gew.-% Niob, 0 Gew.-% bis 1,5 Gew.-% Molybdän und 0 Gew.-% bis 1 Gew.-% Titan enthält.

7. Scheibe nach einem der Ansprüche 1 bis 6, wobei das Substrat (1) Glas enthält, bevorzugt Flachglas, Floatglas, Quarzglas, Borosilikatglas und/oder Kalk-Natron-Glas.

8. Scheibe nach einem der Ansprüche 1 bis 7, wobei die elektrisch leitfähige Struktur (2) zumindest Silber, bevorzugt Silberpartikel und Glasfritten enthält und eine Schichtdicke von 5 µm bis 40 µm aufweist.

9. Scheibe nach einem der Ansprüche 1 bis 8, wobei die Schichtdicke der Lotmasse (4) kleiner oder gleich 6.0 x 10⁻⁴ m ist.

10. Scheibe nach einem der Ansprüche 1 bis 9, wobei die Lotmasse (4) bleifrei ist und bevorzugt Zinn und Wismut, Indium, Zink, Kupfer, Silber oder Zusammensetzungen davon enthält.

11. Scheibe nach Anspruch 10, wobei die Lotmasse (4) 35 Gew.-% bis 69 Gew.-% Wismut, 30 Gew.-% bis 50 Gew.-% Zinn, 1 Gew.-% bis 10 Gew.-% Silber und 0 Gew.-% bis 5 Gew.-% Kupfer enthält.

12. Scheibe nach Anspruch 10, wobei die Lotmasse (4) 90 Gew.-% bis 99,5 Gew.-% Zinn, 0,5 Gew.-% bis 5 Gew.-% Silber und 0 Gew.-% bis 5 Gew.-% Kupfer enthält.

13. Scheibe nach einem der Ansprüche 1 bis 12, wobei das Anschlusselement (3) mit Nickel, Zinn, Kupfer und / oder Silber beschichtet ist.

14. Verwendung einer Scheibe mit mindestens einem elektrischen Anschlusselement nach einem der Ansprüche 1 bis 13, in Gebäuden oder in Fortbewegungsmitteln für den Verkehr auf dem Lande, in der Luft oder zu Wasser, insbesondere in Schienenfahrzeugen oder Kraftfahrzeugen, bevorzugt als Windschutzscheibe, Heckscheibe, Seitenscheibe und / oder Dachscheibe, insbesondere als beheizbare Scheibe oder als Scheibe mit Antennenfunktion.

## Claims

1. A pane with at least one electrical connection element, comprising at least:
- a substrate (1),
- on a region of the substrate (1), an electrically conductive structure (2),
- on a region of the electrically conductive structure (2), a connection element (3) that comprises at least a chromium-containing steel,
wherein the connection element (3) has a region crimped around a connection cable (5), wherein the crimped region of the connection element (3) is directly connected to the electrically conductive structure (2) via a solder material (4), wherein the solder material (4) is not in direct contact to an electrically conductive core of the connection cable (5), wherein the connection element (3) is configured as an open crimp, wherein the connection element (3) has the shape of a B-crimp, wherein the crimp form presents, in profile, two rounded structures resembling the letter "B", wherein the crimp form is disposed on the top of the connection element (3) facing away from the substrate (1), and wherein the contact surface (8) between the connection element (3) and the solder material (4) is disposed opposite the crimp form.

2. Pane according to claim 1, wherein the connection cable (5) includes a stranded wire conductor.

3. Pane according to claim 1 or 2, wherein the material thickness of the connection element (3) is from 0.1 mm to 2 mm, preferably from 0.2 mm to 1 mm, particularly preferably from 0.3 mm to 0.5 mm.

4. Pane according to one of claims 1 through 3, wherein the difference between the coefficient of thermal expansion of the substrate (1) and the coefficient of thermal expansion of the connection element (3) is less than 5 x 10⁻⁶/°C.

5. Pane according to one of claims 1 through 4, wherein the connection element (3) contains at least 66.5 wt.-% to 89.5 wt.-% iron, 10.5 wt.-% to 20 wt.-% chromium, 0 wt.-% to 1 wt.-% carbon, 0 wt.-% to 5 wt.-% nickel, 0 wt.-% to 2 wt.-% manganese, 0 wt.-% to 2.5 wt.-% molybdenum, 0 wt.-% to 2 wt.-% niobium, and 0 wt.-% to 1 wt.-% titanium.

6. Pane according to claim 5, wherein the connection element (3) contains at least 77 wt.-% to 84 wt.-% iron, 16 wt.-% to 18.5 wt.-% chromium, 0 wt.-% to 0.1 wt.-% carbon, 0 wt.-% to 1 wt.-% manganese, 0 wt.-% to 1 wt.-% niobium, 0 wt.-% to 1.5 wt.-% molybdenum, and 0 wt.-% to 1 wt.-% titanium.

7. Pane according to one of claims 1 through 6, wherein the substrate (1) contains glass, preferably flat glass, float glass, quartz glass, borosilicate glass, and/or soda lime glass.

8. Pane according to one of claims 1 through 7, wherein the electrically conductive structure (2) contains at least silver, preferably silver particles and glass frits and has a layer thickness of 5 µm to 40 µm.

9. Pane according to one of claims 1 through 8, wherein the layer thickness of the solder material (4) is less than or equal to 6.0 x 10⁻⁴ m.

10. Pane according to one of claims 1 through 9, wherein the solder material (4) is lead-free and preferably contains tin and bismuth, indium, zinc, copper, silver, or compositions thereof.

11. Pane according to claim 10, wherein the solder material (4) contains 35 wt.-% to 69 wt.-% bismuth, 30 wt.-% to 50 wt.-% tin, 1 wt.-% to 10 wt.-% silver, and 0 wt.-% to 5 wt.-% copper.

12. Pane according to claim 10, wherein the solder material (4) contains 90 wt.-% to 99.5 wt.-% tin, 0.5 wt.-% to 5 wt.-% silver, and 0 wt.-% to 5 wt.-% copper.

13. Pane according to one of claims 1 through 12, wherein the connection element (3) is coated with nickel, tin, copper, and/or silver.

14. Use of a pane with at least one electrical connection element according to one of claims 1 through 13, in buildings or in means of transportation for travel on land, in the air, or on water, in particular in rail vehicles or motor vehicles, preferably as a windshield, rear window, side window, and/or glass roof, in particular as a heatable pane or as a pane with an antenna function.

## Revendications

1. Une vitre avec au moins un élément de connexion électrique, qui comprend au moins:
- un substrat (1),
- sur une zone du substrat (1) une structure électriquement conductrice (2),
- sur une zone de la structure électriquement conductrice (2), un élément de connexion (3), qui contient au moins un acier contenant du chrome,
où l'élément de connexion (3) présente une zone sertie autour d'un câble de raccordement (5), où la zone sertie de l'élément de connexion (3) est reliée directement à la structure électriquement conductrice (2) par une masse de brasure (4), où la masse de brasure (4) n'est pas en contact direct avec un noyau conducteur du câble de raccordement (5),
où l'élément de connexion (3) est conçu comme un sertissage ouvert,
où l'élément de connexion (3) a la forme d'un sertissage B, la forme de sertissage présente en profil deux structures arrondies à la manière de la lettre "B", la forme de sertissage est disposée sur un côté supérieur de l'élément de connexion (3) opposé au substrat (1) et la surface de contact (8) de la structure électriquement conductrice (2) entre l'élément de connexion (3) et la masse de brasure (4) est disposée en face de la forme de sertissage.

2. Vitre selon la revendication 1, où le câble de raccordement (5) contient un conducteur de fil toronné.

3. Vitre selon la revendication 1 ou 2, où l'épaisseur de matériau de l'élément de connexion (3) se situe entre 0,1 mm et 2 mm, de préférence entre 0,2 mm et 1 mm, de manière particulièrement préférée entre 0,3 mm et 0,5 mm.

4. Vitre selon l'une des revendications 1 à 3, où la différence entre le coefficient de dilatation thermique du substrat (1) et le coefficient de dilatation thermique de l'élément de connexion (3) est inférieure à 5 x 10⁻⁶/°C.

5. Vitre selon l'une des revendications 1 à 4, où l'élément de connexion (3) contient au moins 66,5% à 89,5% en poids de fer, 10,5% à 20% en poids de chrome, 0% à 1% en poids de carbone, 0% à 5% en poids de nickel, 0% à 2% en poids de manganèse 0% à 2,5% en poids de molybdène, 0% à 2% en poids de niobium et 0% à 1% en poids de titane.

6. Vitre selon la revendication 5, où l'élément de connexion (3) contient au moins 77% à 84% en poids de fer, 16% à 18,5% en poids de chrome, 0 à 0,1% en poids de carbone, 0% à 1% en poids de manganèse, 0% à 1% en poids de niobium, 0 % à 1,5% en poids de molybdène et 0% à 1% en poids de titane.

7. Vitre selon l'une des revendications 1 à 6, où le substrat (1) contient du verre, de préférence du verre plat, du verre flottée, du verre de quartz, du verre borosilicaté et/ou du verre sodocalcique.

8. Vitre selon l'une des revendications 1 à 7, où la structure électriquement conductrice (2) contient au moins de l'argent, de préférence des particules d'argent et des frittes de verre et présente une épaisseur de couche de 5 µm à 40 µm.

9. Vitre selon l'une des revendications 1 à 8, où l'épaisseur de couche de la masse de brasure (4) est inférieure ou égal à 6,0 x 10⁻⁴m.

10. Vitre selon l'une des revendications 1 à 9, où la masse de brasure (4) est sans plomb et de préférence contient de l'étain et bismuth, de l'indium, du zinc, du cuivre, de l'argent ou des mélanges de ceux-ci.

11. Vitre selon la revendication 10, où la masse de brasure (4) contient de 35% à 69% en poids de bismuth, de 30% à 50% en poids d'étain, de 1% à 10% en poids d'argent et 0 % à 5% en poids de cuivre.

12. Vitre selon la revendication 10, où la masse de brasure (4) contient 90% à 99,5% en poids d'étain, 0,5% à 5% en poids d'argent et 0% à 5% en poids de cuivre.

13. Vitre selon l'une des revendications 1 à 12, où l'élément de connexion (3) est revêtu de nickel, de l'étain, de cuivre et/ou d'argent.

14. Utilisation d'une vitre avec au moins un élément de connexion électrique selon l'une des revendications 1 à 13, dans les bâtiments ou les moyens de locomotion pour le transport sur la terre, dans l'air ou dans l'eau, en particulier dans des véhicules ferroviaires ou des véhicules à moteur, de préférence comme pare-brise, lunette arrière, vitre latérale et/ou vitre de toit, en particulier comme vitre chauffante ou vitre avec fonction d'antenne.
